# EUROPEAN PATENT SPECIFICATION

(11) **EP 2 786 207 B1**
(45) Date of publication and mention of the grant of the patent: **10.02.2016**
(21) Application number: 12799409.3
(22) Date of filing: 25.11.2012
(51) Int. Cl.: G03F 7/18, B41C 1/10

(54) **METHOD FOR MAKING FLEXOGRAPHIC PRINTING FORMS BY WELDING EDGES OF PHOTOSENSITIVE ELEMENTS WITH MICROWAVE ENERGY**
VERFAHREN ZUR HERSTELLUNG VON FLEXODRUCKFORMEN DURCH KANTENSCHWEISSUNG LICHTEMPFINDLICHER ELEMENTE MITTELS MIKROWELLENENERGIE
PROCÉDÉ DE FABRICATION DE FORMES D'IMPRESSION FLEXOGRAPHIQUE PAR SOUDAGE MICRO-ONDE DES BORDS D'ÉLÉMENTS PHOTOSENSIBLES

(30) Priority: 02.12.2011 US 201113310232
(43) Date of publication of application: 08.10.2014
(73) Proprietor: E. I. du Pont de Nemours and Company, Wilmington, DE 19805 (US)
(72) Inventor: MEHDIZADEH, Mehrdad, Avondale, Pennsylvania 19311 (US); PERROTTO, Joseph Anthony, Landenberg, Pennsylvania 19350 (US)
(74) Representative: de Bresser, Sara Jean
(86) International application number: PCT/US2012/066482
(87) International publication number: WO 2013/081951

(56) References cited:
- GB-A- 1 579 817
- US-A- 5 338 611
- US-A- 5 379 693
- US-A1- 2007 125 489

## Description

### BACKGROUND OF THE INVENTION

### Field of the Invention

This invention pertains to a process for making flexographic printing forms, particularly relief printing forms, from two or more photosensitive elements welded to one another at their edges, wherein the welding is accomplished by microwave energy. This invention also relates to sealing edges of a cylindrically-shaped photosensitive element. Using microwave energy provides a smooth surface upon welding with a near disappearance of the weld-lines.

### Description of Related Art

Flexographic printing plates are well-known for use in printing surfaces that range from soft and easy to deform to relatively hard, such as packaging materials, e.g., cardboard, plastic films, aluminum foils, etc. Flexographic printing plates can be prepared from photosensitive elements containing photopolymerizable compositions, such as those described in U.S. Patents 4,323,637 and 4,427,759. The photopolymerizable compositions generally comprise an elastomeric binder, at least one monomer, and a photoinitiator. Photosensitive elements generally have a photopolymerizable layer interposed between a support layer and a coversheet or multilayer cover element. Upon imagewise exposure to actinic radiation, photopolymerization of the photopolymerizable layer occurs in the exposed areas, thereby curing and rendering insoluble the exposed areas of the layer.

Conventionally, the element is treated with a suitable solution, e.g., solvent or aqueous-based washout, to remove the unexposed areas of the photopolymerizable composition layer leaving a printing relief which can be used for flexographic printing. As an alternative to solution development, a "dry" thermal development process may be used which removes the unexposed areas. In the thermal development process, the photopolymerizable layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens); and 5,279,697 (Peterson et al.).

Photopolymerizable materials can be formed into sheets or layers by several known methods such as solvent casting, hot pressing, calendering and extrusion. A preferred method of forming photopolymerizable materials for use as flexographic printing elements is by extrusion-calendering the photopolymerizable material. The films can include multiple layers or compound films. The printing element as a multilayer web can be cut into suitable size sheets. Extrusion and calendering of polymeric compositions are disclosed, for example, in Gruetzmacher et al., U.S. Patent 4,427,759.

However, in many of the applications, it becomes necessary to fuse or weld two sheets of photosensitive elements to create a larger element or to create an element of a particular shape. The welding of such two or more photosensitive elements should create a seam that does not interfere with the fine relief structure that will eventually develop upon removal of unirradiated or uncured material from the photosensitive element that has been imagewise exposed to actinic radiation. It is imperative that the weld-lines or the seam not develop prominent features to avoid interference. To form weld-lines that will cause only minimal interference to the relief structures, the welding should be localized. The source of energy that softens and melts the edges of the photosensitive elements should beam the energy very precisely and only locally upon those areas around and upon the seam or the weld-line, at the same time avoiding any other areas of the photosensitive elements from heating or softening. Needless to say that the energy source should be such that the edge material of the photosensitive element softens and melts. Clearly, the welding should be accomplished in as less a time as possible.

While typical photopolymerizable printing elements are used in sheet form, there are particular applications and advantages to using the printing element in a continuous cylindrical form. Continuous printing elements have applications in the flexographic printing of continuous designs such as in wallpaper, decoration and gift wrapping paper, and tight-fit conditions for registration, since the designs can be easily printed without print-through of the plate seam. Furthermore, such continuous printing elements are well-suited for mounting on laser exposure equipment where it can replace the drum, or be mounted on the drum for exposure by a laser to achieve precise registration. In addition, registration of multicolor images is greatly enhanced and facilitated by mounting cylindrically-shaped printing forms on a printing press.

The formation of continuous printing elements can be accomplished by several methods. The photopolymerizable flat sheet elements can be reprocessed by wrapping the element around a cylindrical form, usually a printing sleeve support or the printing cylinder itself, and then heating to join the edges together to form a continuous element. Processes for joining the edges of a plate into a cylindrical form have been disclosed, for example, in German Patent DE 28 44 426, United Kingdom Patent GB 1 579 817, European Patent Application EP 0 469 375, U.S. Patent 4,883,742, and U.S. Patent 4,871,650. These processes can take extended periods of time to completely form the cylindrical printing element since the sheet is heated after wrapping to bring the sheet up to a temperature to join the edges.

Generally, any non-uniformity in the thickness of the cylindrical photosensitive layer, particularly at the locale where the first and second ends fused, or surface disturbances, can be removed by grinding the photosensitive layer to the desired thickness uniformity. Grinding with a grinding stone is a conventional method for removing excess polymeric material to provide desired thickness uniformity.

In the above processes for cylindrically-shaped photosensitive elements, the edges of the photopolymerizable layer have to be sealed, for example, by heating or by adhesion. If the photopolymerizable layer is applied to the cylindrically-shaped support using an adhesive, bubbles or unevenness due to the adhesive is evident on the photopolymerizable layer. When heating is used for applying the photopolymerizable layer to the cylindrically-shaped support, the sealing is accomplished when the two edges fuse with each other creating a seam or when the two edges overlap each other creating a strip that is twice as thick as the photopolymerizable layer. Thus, a cylindrically-shaped photosensitive element is likely to have uneven or non-uniform surface, either due to the seam created upon fusion or adhesion of the two ends of the photopolymerizable layer (the "seam effect"), the overlap of the two ends (the "overlap effect"), the adhesive layer-related bubbles or other defects ("adhesion non-uniformity"), or any other reason ("other non-uniformity") that renders the photopolymerizable layer surface non-uniform. The seam effect, the overlap effect, adhesion non-uniformity, or other non-uniformities (hereinafter collectively called as "non-uniformities") can create problems in subsequent relief printing where the non-uniformities are transcribed on the printing surface as unwanted defects. In order to avoid the transcription of the non-uniformities in the finished products for which the cylindrically-shaped printing forms are used, i.e., for printing substrates, the photopolymerizable layer should be rendered seamless and smooth. Thus, there is a need for an easy, relatively quick, and productive method for making seamless and smooth cylindrically-shaped photosensitive elements, that mitigates the seam effect, the overlap effect, adhesion non-uniformity, and other non-uniformities.

Thus, whether the photosensitive element is a flat sheet or cylindrical, a need exists for a seamless welding of two edges of photosensitive elements, two edges of two different photosensitive elements in case of a flat-sheet, and two edges of the same cylindrically-shaped photosensitive element. At the same time, the energy should be provided very precisely at the edges to be welded or sealed, without substantially impacting adjacent areas of the photosensitive elements. Also, the welding process should be accomplished very rapidly without any impact to any other areas of the photosensitive elements, whether in terms of disturbance of the topography of the photosensitive element or the physical properties of the photosensitive elements. The present invention addresses the above needs.

### SUMMARY OF THE INVENTION

The present invention relates to a process for welding at least two photosensitive elements to each other, for use as a printing form, comprising:
(a) providing said at least two photosensitive elements, each comprising a photosensitive layer comprising a thermoplastic binder, a monomer and a photoinitiator;
(b) placing said at least two photosensitive elements side-by-side such that an edge of the first photosensitive element to be welded with an edge of the second photosensitive element are in intimate contact with one another and form a weld-line; and
(c) applying microwave-radiation from a microwave-radiation means, wherein said microwave-radiation impinges on an area substantially proximate to said edges.

In another embodiment, the present invention also relates to a process for welding two edges of a cylindrically-shaped photosensitive element to each other, for using said photosensitive element as a printing form, the process comprising:
(a) providing said photosensitive element, comprising a photosensitive layer comprising a thermoplastic binder, a monomer and a photoinitiator;
(b) placing said two edges of the cylindrically-shaped photosensitive element side-by-side such that the two edges to be welded to each other are in intimate contact with one another and form a weld-line; and
(c) applying microwave-radiation from a microwave-radiation means, wherein said microwave-radiation impinges on an area substantially proximate to said edges.

### BRIEF DESCRIPTION OF THE DRAWINGS

The invention can be more fully understood from the following detailed description thereof in connection with the accompanying drawing described as follows:
Figure 1A is a schematic displaying the microwave welding of two planar photosensitive plates.
Figure 1B is a schematic of the same embodiment disclosed the Figure 1, but shows the embodiment from a top view.
Figure 2 is a schematic perspective view of a second embodiment of the present invention depicting the microwave means for welding a cylindrically-shaped photosensitive element onto a support.
Figure 3 is a schematic perspective view of a third embodiment of the present invention depicting the microwave means for welding two cylindrically-shaped photosensitive elements to each other.
Figure 4 is a schematic perspective view of a fourth embodiment of the present invention depicting two planar photosensitive plates by with a non-uniform weld-line.

### DESCRIPTION OF THE PREFERRED EMBODIMENT(S)

Throughout the following detailed description, similar reference characters refer to similar elements in all figures of the drawings.

In one embodiment, the present invention relates to a process for welding at least two photosensitive elements (plates) to each other, for use as a printing form, for example, two planar (flat-sheet) photosensitive elements or two cylindrically-shaped photosensitive elements placed side-by-side. The invention also relates to a process for welding two edges of a photosensitive element in a cylindrical configuration. The welding or sealing of the edges is accomplished by microwave energy. In the electromagnetic spectrum, radiation in the frequency range of 300 MHz to 30 GHz is generally referred to as microwave radiation. We note that 1 GHz is equal to 1,000 MHz. This wavelength range has found considerable use in industries such as cooking and drying, due to the response of water molecules to this excitation. For example, the prevalent frequency of microwave cooking appliances is 2.45 GHz, which is optimal for heating water in its free and bound states.

In particular, the present invention contemplates a process capable of heating and welding the edges of photosensitive elements using microwave-radiation. The photosensitive elements have a photosensitive layer or a photopolymerizable composition layer capable of being partially liquefied to a temperature sufficient to melt or soften or flow ("liquefy") at least a portion of the photopolymerizable composition layer. In one embodiment, the process comprises providing at least two photosensitive elements, each comprising a photosensitive layer comprising a thermoplastic binder, a monomer and a photoinitiator; placing said at least two photosensitive elements side-by-side, such that an edge of the first photosensitive element to be welded with an edge of the second photosensitive element are in intimate contact with one another, forming a weld-line; and applying microwave-radiation from a microwave-radiation means, wherein said microwave-radiation impinges on an area substantially proximate to said edges where the sealing or welding is desired. The heat converges in this area. Stated another way, the entire photosensitive plate or even large portions thereof need not be heated and liquefied for sealing purposes. Hereinafter, the substantially proximate area around the weld-line, where the two edges meet, will be termed as "localized zone of heating." Hereinafter, the process of the present invention will also be referred to as the "microwave-welding process."

Optionally, a thin layer of microwave susceptible implant (electromagnetic absorbent material) is inserted between the two edges along the weld-line of the photosensitive elements that are being welded in the presence of welding pressure. The microwave energy induces a temperature increase in the electromagnetic absorbent material and consequently the electromagnetic absorbent material conducts heat to the two photosensitive elements and the weld-line, creating a molten layer of the polymer at the interface. When the microwave-radiation is incident on the component, the energy propagates through the thermoplastic photosensitive plate but is absorbed by the microwave susceptible implant causing heating. The electromagnetic absorbent material can be heated with different mechanisms, such as eddy current, hysteresis, or dielectric loss. As the temperature of the implant reaches the softening point of the surrounding thermoplastic in the photosensitive elements, the material begins the flow across the joint and a weld is formed as the thermoplastic cools under pressure with the microwave energy now off. Photosensitive elements with low-to-medium dielectric loss factors require no electromagnetic absorbent material in the weld-line. The temperature of the weld-line increases and reaches the melting temperature of the polymer as the weld-line passes underneath the focused microwave-radiation. Meanwhile localized fusion occurs in the presence of pressure, resulting in a weld. Photosensitive elements with high dielectric loss factors require electromagnetic absorbent materials at the interface. Under focused microwave-radiation, the electromagnetic absorbent materials absorb microwave energy more rapidly than photosensitive elements, and then evaporate and leave a localized zone of heating at the weld-line. The fusion bonding occurs in the weld-line in presence of pressure resulting in a weld. Typical electromagnetic absorbent materials include materials and solvents with -OH, -CO, -NO, and -NH bonds. During the welding process, some of these materials evaporate and some remain in the weld area.

In a subsequent step, the welded photosensitive elements are imagewise exposed to actinic radiation. The imagewise exposure to actinic radiation cures portions of the photopolymerizable layer. It is followed by development of the flexographic plate that includes the conventional step of solvent-based development of the photosensitive element. In the solvent-based development, a solvent (solution) dissolves the uncured or unirradiated portions of the photopolymerizable compositions layer, which is carried away by contact with a development medium. Alternatively, after the imagewise exposure, the photosensitive plate may be developed thermally. In thermal development, the photosensitive element is thermally heated to a development temperature that causes uncured or unirradiated portions of the photopolymerizable composition layer to liquefy, and be carried away by contact with the development medium. In both cases, the photopolymerizable composition layer is capable of being partially liquefied. The development medium is also called as development material, absorbent material, development web, absorbent web, or web. Cured or unirradiated portions of the photopolymerizable composition layer have a melting or softening or liquefying temperature higher than the uncured or unirradiated portions of the photopolymerizable composition layer and therefore do not liquefy at the thermal development temperatures. Thermal development of photosensitive elements to form flexographic printing plates is described in U.S. 5,015,556; U.S. 5,175,072; U.S. 5,215,859; and WO 98/13730. However, the present invention is amenable to using either the solvent-based development or the thermal development process.

The term "melt" is used to describe the behavior of the uncured or unirradiated portions of the photopolymerizable composition layer subjected to an elevated temperature that softens and reduces the viscosity to permit absorption by the absorbent material. The material of the meltable portion of the photopolymerizable composition layer is usually a viscoelastic material which does not have a sharp transition between a solid and a liquid, so the process functions to absorb the heated photopolymerizable composition layer at any temperature above some threshold for absorption in the development medium. Thus, the uncured or unirradiated portions of the photopolymerizable composition layer soften or liquefy when subjected to an elevated temperature. However throughout this specification the terms "melting," "softening," and "liquefying," may be used to describe the behavior of the heated, uncured or unirradiated portions of the photopolymerizable composition layer, regardless of whether the composition may or may not have a sharp transition temperature between a solid and a liquid state. A wide temperature range may be utilized to "melt" the photopolymerizable composition layer for the purposes of this invention. Absorption may be slower at lower temperatures and faster at higher temperatures during successful operation of the process.

The photosensitive element in all embodiments is in the form of a plate. Two photosensitive plates may be clamped onto a flat base for sealing edges of the two plates side-by-side, or a single plate may be clamped onto a drum for welding the edges to prepare a cylindrical element. In the alternative, in an embodiment, two plates may be clamped onto a drum to weld the cylindrical edges of the two plates placed side-by-side.

In one embodiment of the invention, microwave welding includes heating the localized zone of heating of two plate edges placed side-by-side. The microwave-radiation impinging on the localized zone of heating that includes the two proximately placed edges heats the exterior surface of the photopolymerizable composition layer of the photosensitive elements to a temperature Tᵣ sufficient to cause a portion of the layer to liquefy. More specifically, in the present invention, the entire photosensitive element is not heated at the same time, instead the microwave-radiation means traverses along the welding edges of the two photosensitive elements. The microwave-welding is repeated, if desired, along the weld-line.

At least one photopolymerizable composition layer (and additional layer/s if present) is heated by microwave-radiation to a temperature sufficient to effect melting of the curable portion of the photopolymerizable layer that results into welding of the two photosensitive plates.

In one embodiment, the present invention provides a process for making a seamless and smooth cylindrically-shaped photosensitive element for use as a printing form. The microwave-radiation impinging on the localized zone of heating that includes the two proximately placed edges heats the exterior surface of the photopolymerizable composition layer of the photosensitive elements to a temperature Tᵣ sufficient to cause a portion of the layer to liquefy. The process provides a cylindrically-shaped photosensitive element from a formed layer of photosensitive composition with smooth and seamless surface without non-uniformities or substantially reduced level of non-uniformities. The photosensitive element is adapted after imagewise exposure and treatment to become a cylindrical printing element having a surface suitable for printing.

In the present invention, prior to imagewise exposure of the photosensitive element, the outer surface of the photosensitive layer (photopolymerizable layer) is heated to high temperatures. By high temperatures is meant temperatures sufficient to cause the layer at the ends to soften. Generally, speaking, a temperature that is above the glass-transition temperature of the polymeric material in the photosensitive element should be sufficient to soften the outer surface of the photosensitive layer.

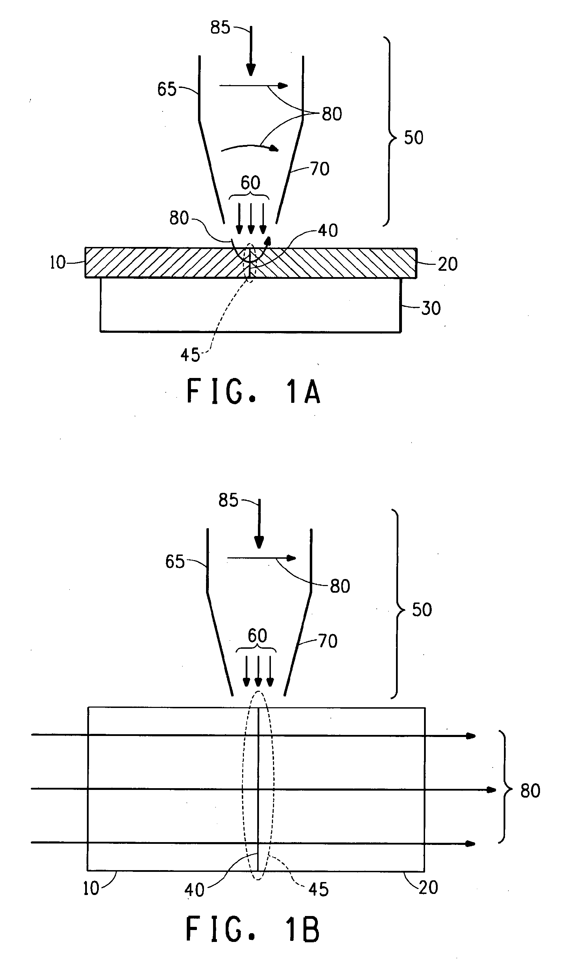

Figures 1A and 1B describe one embodiment of the present invention. As shown in Figs. 1A and 1B two photosensitive plates (10 & 20) are placed side-by-side on a backing (30) made from, for example, polytetrafluoroethylene (PTFE). The two plates are in edgewise contact with each other forming the weld-line (40). The region substantially proximate to the proposed weld-line (40) is called the localized zone of heating (45). This region (45) is more likely that other areas of the two plates (10 & 20) to undergo some form of melting or liquefaction, as a result of impingement of the microwave-radiation (50).

The microwave-radiation is provided from a microwave-radiation means or the microwave apparatus (50) that comprises a microwave waveguide (65). The microwave waveguide (65) has the microwave applicator (70) attached to it. The microwave applicator (70) generally moves in a direction along the weld-line (40). The electric field (80) is in a direction parallel to plane of the photosensitive plates (10 & 20). However, the microwave energy flow (85) is in a direction perpendicular to this field (80). The electric field (80) penetrates the two photosensitive plates (10 & 20) in the localized zone of heating (45). The microwave energy (85) transferred as a result to the two plates (10 & 20) and to the weld-line (40) helps create the welding between the two plates (10 & 20). The microwave-radiation (60) impinge on the weld-line (40) for a few seconds only-from about 1 second to about 120 seconds.

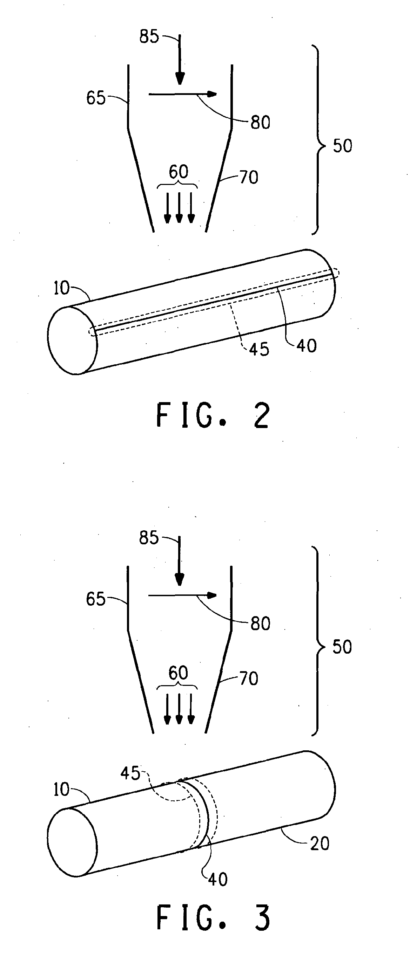

Fig. 2 shows another embodiment of the present invention. Fig. 2 shows a single photosensitive plate (10), cylindrically-shaped, mounted on a support (not shown). The two edges of the photosensitive plate (10) form the weld-line (40) that is to be sealed together using microwave-radiation. The region substantially proximate to the proposed weld-line (40) is called the localized zone of heating (45). This region (45) is more likely that other areas of the plate (10) to undergo some form of melting or liquefaction, as a result of impingement of the microwave-radiation (60).

The microwave-radiation is provided from a microwave apparatus (50) that comprises a microwave waveguide (65) with a microwave applicator (70) attached to it. The microwave applicator (70) generally moves in a direction along the weld-line (40). The electric field (80) is in a direction parallel to the tangential direction of the weld-line (40). However, the microwave energy flow (85) is in a direction perpendicular to this field (80). The electric field (80) penetrates the photosensitive plate (10) in the localized zone of heating (45). The microwave energy (85) transferred as a result to the plate (10) and to the weld-line (40) helps create the welding between the two edges. The microwave-radiation (60) impinges on the weld-line (40) for a few seconds only-from about 1 second to about 120 seconds.

Figure 3 describes another embodiment of the present invention. As shown in Fig. 3, two cylindrically-shaped photosensitive plates (10 & 20) are placed side-by-side on a cylindrical support (not shown). The two plates are in edgewise contact with each other (40). The region substantially proximate to the proposed weld-line (40) is called the localized zone of heating (45). This region (45) is more likely than other areas of the two plates (10 &20) to undergo some form of melting or liquefaction, as a result of impingement of the microwave-radiation (50).

The microwave-radiation is provided from a microwave apparatus (50) that comprises a microwave waveguide (65). The microwave waveguide (65) has the microwave applicator (70) attached to it. The microwave applicator (70) generally moves in a direction along the weld-line (40). In this embodiment, the two cylindrically-shaped photosensitive plates (10 & 20) are capable of moving on their axis as a result of the movement by the support. The electric field (80) is in a direction parallel to plane of the photosensitive plates (10 & 20). However the microwave energy flow (85) is in a direction perpendicular to this field (80). The electric field (80) penetrates the two photosensitive plates (10 7 20) in the localized zone of heating (45). The microwave energy (85) transferred as a result to the two plates (10 & 20) and to the weld-line (40) helps create the welding between the two plates (10 & 20). The residence time of microwave-radiation (60) impinging on the weld-line (40) for a few seconds only-from about 1 second to about 120 seconds. The rotational speed of the photosensitive plates (10 & 20) can be controlled in such manner so as to provide a desired residence time of exposure of a particular spot on the weld-line (40).

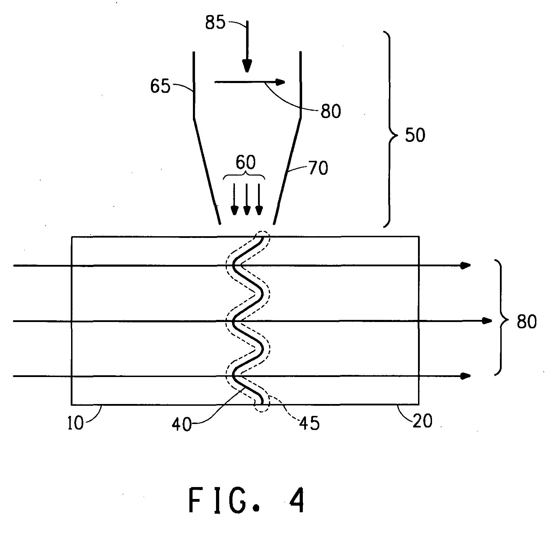

Similarly, Figure 4 describes another embodiment of the present invention. Two photosensitive plates (10 & 20) are placed side-by-side on a backing (30) made from, for example, polytetrafluoroethylene (PTFE). The two plates are in edgewise contact with each other (40). The region substantially proximate to the proposed weld-line (40) is called the localized zone of heating (45). This region (45) is more likely that other areas of the two plates (10 & 20) to undergo some form of melting or liquefaction, as a result of impingement of the microwave-radiation (50). In this embodiment, as shown in Fig. 4, the weld-line (40) is not straight but can assume a non-uniform shape. The second photosensitive plate can be cut in such manner that the two edges match up to provide a weld-line (40). The microwave apparatus (50) is capable of traversing along the non-uniform-shaped weld-line (40), stay at a particular locus on the weld-line for a pre-determined time, and move along the weld-line (40) to accomplish the welding. The microwave apparatus can be programmed to move along the weld-line (40) to provide an efficient seal.

The process of the present invention can be used prior to the imagewise exposure of photosensitive plates to actinic radiation. However, in an alternate embodiment, an imagewise exposed plate or plates can also be welded using microwave-radiation.

In one embodiment, the microwave-radiation is in the preferred frequency ranges as follows:
from about 300 MHz to about 30,000 MHz;
from about 400 MHz to about 24,000 MHz;
from about 425 MHz to about 950 MHz;
from about 425 MHz to about 450 MHz;
from about 885 MHz to about 925 MHz;
from about 2400 MHz to about 2600 MHz;
from about 2435 MHz to about 2460 MHz;
from about 5,700 MHz to about 5,900 MHz;
from about 5,785 MHz to about 5,810 MHz;
from about 23,985 MHz to about 24,010 MHz.

Further preferred frequencies of microwave-radiation include 433 MHz, 896 MHz, 915 MHz, 2450 MHz, 5800 MHz, and 24,000 MHz.

In one embodiment, the time for microwave-radiation exposure is in the range of from about 1 seconds to about 120 seconds at a given location. In a preferred embodiment, the time for microwave-radiation exposure is in the range of from about 1 second to about 20 seconds. A further preferred range for exposure is from about 1 second to 10 seconds.

In one embodiment, the microwave power supplied is in the range of from about 100 W to 2,000 W. In a preferred embodiment of the invention, the microwave power supplied is in the range of from about 400W to about 2500W. In a further preferred range, the power is from about 450 W to 800 W.

### Photosensitive Element-General

As discussed previously, this invention relates to edge-welding two or more photosensitive elements. Preferably, the edge-welding is accomplished by impinging microwave-radiation on the elements at the localized zone of heating and before the photosensitive elements are imagewise exposed to actinic radiation.

Photosensitive elements welded to each other on one edge and subsequently used for preparing flexographic printing forms includes at least one layer of a photopolymerizable composition. The term "photosensitive" encompasses any system in which the at least one photosensitive layer is capable of initiating a reaction or reactions, particularly photochemical reactions, upon response to actinic radiation. In some embodiments, the photosensitive element includes a support for the photopolymerizable composition layer. In some embodiments, the photopolymerizable composition layer is an elastomeric layer that incudes a binder, at least one monomer, and a photoinitiator. The binder can be a thermoplastic binder. The photoinitiator has sensitivity to actinic radiation. Throughout this specification, actinic radiation will include ultraviolet radiation and/or visible light. In some embodiments, the photosensitive element includes a layer of an actinic radiation opaque material adjacent the photopolymerizable composition layer, opposite the support. In other embodiments, the photosensitive element includes an image of actinic radiation opaque material suitable for use as an in-situ mask adjacent the photopolymerizable composition layer.

Unless otherwise indicated, the term "photosensitive element" encompasses printing precursors capable of undergoing exposure to actinic radiation and treating, to form a surface suitable for printing. Unless otherwise indicated, the "photosensitive element" and "printing form" includes elements or structures in any form which become suitable for printing or are suitable for printing, including, but not limited to, flat sheets, plates, seamless continuous forms, cylindrical forms, plates-on-sleeves, and plates-on-carriers. It is contemplated that printing form resulting from the photosensitive element has end-use printing applications for relief printing, such as flexographic and letterpress printing. Relief printing is a method of printing in which the printing form prints from an image area, where the image area of the printing form is raised and the non-image area is depressed.

The photosensitive element includes at least one layer of a photopolymerizable composition. As used herein, the term "photopolymerizable" is intended to encompass systems that are photopolymerizable, photocrosslinkable, or both. The photopolymerizable composition layer is a solid elastomeric layer formed of the composition comprising a binder, at least one monomer, and a photoinitiator. The photoinitiator has sensitivity to actinic radiation. Throughout this specification actinic light will include ultraviolet radiation and/or visible light. The solid layer of the photopolymerizable composition is treated with one or more solutions and/or heat to form a relief suitable for flexographic printing. As used herein, the term "solid" refers to the physical state of the layer which has a definite volume and shape and resists forces that tend to alter its volume or shape. The layer of the photopolymerizable composition is solid at room temperature, which is a temperature between about 5°C and about 30°C. A solid layer of the photopolymerizable composition may be polymerized (photohardened), or unpolymerized, or both.

The photosensitive layer melts or flows at the glass transition temperature. The material of the photosensitive layer is usually a viscoelastic material which does not have a sharp transition between a solid and a liquid, and thus the glass transition temperature may not have a sharp transition temperature between a solid and a liquid state. Preheating of the photosensitive layer to less than its glass transition temperature avoids the viscoelastic material from flowing or melting. Preheating the photosensitive layer to any temperature sufficient to cause the layer to soften and/or become tacky, but below the threshold to flow or melt, is suitable. However throughout this specification the term "softening" may be used to describe the behavior of the preheated photosensitive layer, regardless of whether the composition may or may not have a sharp transition temperature between a solid and a liquid state. A wide temperature range may be utilized to "soften" the photosensitive layer for the purposes of this invention. Sealing as well as fusing of the ends may be slower at lower temperatures and faster at higher temperatures during successful operation of the process.

In most instances in this invention, the seam or the weld-line in microwave-radiation sealed adjacent ends will be visible on the exterior surface of the cylindrical photosensitive element. In other cases, the seam or weld-line in sealed adjacent ends will become apparent during printing. Welding of the adjacent ends of the photosensitive layer means that the adjacent ends are held and bonded together to form a continuous layer on the support, such that a line of demarcation, or a seam or the weld-line where the adjacent ends met, is not present, and if present does not preferably interfere with the relief features to be developed on the plate. After laminating and fusing, the photosensitive layer becomes a continuum of photosensitive material and the photosensitive element can be considered seamless.

The binder in the photopolymerizable layer is not limited and can be a single polymer or mixture of polymers. In some embodiments, the binder is an elastomeric binder. In other embodiments, the binder becomes elastomeric upon exposure to actinic radiation. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. In some embodiments, the binder is an elastomeric block copolymer of an A-B-A type block copolymer, where A represents a non-elastomeric block, and B represents an elastomeric block. The non-elastomeric block A can be a vinyl polymer, such as for example, polystyrene. Examples of the elastomeric block B include polybutadiene and polyisoprene. In some embodiments, the elastomeric binders include poly(styrene/isoprene/styrene) block copolymers and poly(styrene/butadiene/styrene) block copolymers. The non-elastomer to elastomer ratio of the A-B-A type block copolymers can be in the range of from 10:90 to 35:65. The binder can be soluble, swellable, or dispersible in aqueous, semi-aqueous, water, or organic solvent washout solutions. Elastomeric binders which can be washed out by treating in aqueous or semi-aqueous developers have been disclosed by Proskow, in U.S. Patent 4,177,074; Proskow in U.S. Patent 4,431,723; Worns in U.S. Patent 4,517,279; Suzuki et al. in U.S. 5,679,485; Suzuki et al. in U.S. 5,830,621; and Sakurai et al. in U.S. 5,863,704. The block copolymers discussed in Chen, U.S. Patent 4,323,636; Heinz et al., U.S. Patent 4,430,417; and Toda et al., U.S. Patent 4,045,231 can be washed out by treating in organic solvent solutions. Generally, the elastomeric binders which are suitable for washout development are also suitable for use in thermal treating wherein the unpolymerized areas of the photopolymerizable composition layer soften, melt, or flow upon heating. It is preferred that the binder be present in an amount of at least 50 % by weight of the photosensitive composition.

The term binder, as used herein, encompasses core shell microgels and blends of microgels and performed macromolecular polymers, such as those disclosed in Fryd et al., U.S. Patent 4,956,252 and Quinn et al., U.S. Patent 5,707,773.

Other suitable photosensitive elastomers that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete description of some of these materials see U.S. Pat. No. 5,015,556.

The photopolymerizable composition contains at least one compound capable of addition polymerization that is compatible with the binder to the extent that a clear, non-cloudy photosensitive layer is produced. The at least one compound capable of addition polymerization may also be referred to as a monomer. Monomers that can be used in the photopolymerizable composition are well known in the art and include, but are not limited to, addition-polymerization ethylenically unsaturated compounds with at least one terminal ethylenic group. Generally the monomers have relatively low molecular weights (less than about 30,000). In some embodiments the monomers have a relatively low molecular weight less than about 5000. Unless otherwise indicated, the molecular weight is the weighted average molecular weight. The addition polymerization compound may also be an oligomer, and can be a single or a mixture of oligomers. Some embodiments include a polyacrylol oligomer having a molecular weight greater than 1000. The composition can contain a single monomer or a combination of monomers. The monomer compound is present in at least an amount of 5%, and in some embodiments 10 to 20%, by weight of the composition.

Suitable monomers include, but are not limited to, acrylate monoesters of alcohols and polyols; acrylate polyesters of alcohols and polyols; methacrylate monoesters of alcohols and polyols; and methacrylate polyesters of alcohols and polyols; where the alcohols and the polyols suitable include alkanols, alkylene glycols, trimethylol propane, ethoxylated trimethylol propane, pentaerythritol, and polyacrylol oligomers. Other suitable monomers include acrylate derivatives and methacrylate derivatives of isocyanates, esters, epoxides, and the like. Combinations of monofunctional acrylates, multifunctional acrylates, monofunctional methacrylates, and/or multifunctional methacrylates may be used. Other examples of suitable monomers include acrylate and methacrylate derivatives of isocyanates, esters, epoxides and the like. In some end-use printing forms it may be desirable to use monomer that provide elastomeric properties to the element. Examples of elastomeric monomers include, but are not limited to, acrylated liquid polyisoprenes, acrylated liquid butadienes, liquid polyisoprenes with high vinyl content, and liquid polybutadienes with high vinyl content, (that is, content of 1-2 vinyl groups is greater than about 20% by weight).

Further examples of monomers can be found in U.S. Patent 2,927,024; Chen, U.S. Patent No. 4,323,636; Fryd et al., U.S. Patent No. 4,753,865; Fryd et al., U.S. Patent No. 4,726,877 and Feinberg et al., U.S. Patent No. 4,894,315.

The photoinitiator can be any single compound or combination of compounds which is sensitive to actinic radiation, generating free radicals which initiate the polymerization of the monomer or monomers without excessive termination. Any of the known classes of photoinitiators, particularly free radical photoinitiators such as quinones, benzophenones, benzoin ethers, aryl ketones, peroxides, biimidazoles, benzyl dimethyl ketal, hydroxyl alkyl phenyl acetophenone, dialkoxy acetophenone, trimethylbenzoyl phosphine oxide derivatives, aminoketones, benzoyl cyclohexanol, methyl thio phenyl morpholino ketones, morpholino phenyl amino ketones, alpha halogennoacetophenones, oxysulfonyl ketones, sulfonyl ketones, oxysulfonyl ketones, benzoyl oxime esters, thioxanthrones, ketocoumarins, and Michler's ketone may be used. Alternatively, the photoinitiator may be a mixture of compounds in which one of the compounds provides the free radicals when caused to do so by a sensitizer activated by radiation. Preferably, the photoinitiator for the main exposure (as well as post-exposure and backflash) is sensitive to visible or ultraviolet radiation, between 310 to 400 nm, and preferably 345 to 365 nm. A second photoinitiator sensitive to radiation between 220 to 300 nm, preferably 245 to 265 nm, may optionally be present in the photopolymerizable composition. After treating, a plate can be finished with radiation between 220 to 300 nm to detackify the relief surfaces. The second photoinitiator decreases the finishing exposure time necessary to detackify the plate. Photoinitiators are generally present in amounts from 0.001% to 10.0% based on the weight of the photopolymerizable composition.

The photopolymerizable composition can contain other additives depending on the final properties desired. Additional additives to the photopolymerizable composition include sensitizers, plasticizers, rheology modifiers, thermal polymerization inhibitors, colorants, processing aids, antioxidants, antiozonants, dyes, and fillers.

Plasticizers are used to adjust the film forming properties of the elastomer. Examples of suitable plasticizers include aliphatic hydrocarbon oils, e.g., naphthenic and paraffinic oils; liquid polydienes, e.g., liquid polybutadiene; liquid polyisoprene; polystyrene; poly-alpha-methyl styrene; alpha-methylstyrene-vinyltoluene copolymers; pentaerythritol ester of hydrogenated rosin; polyterpene resins; and ester resins. Generally, plasticizers are liquids having molecular weights of less than about 5000, but can have molecular weights up to about 30,000. Plasticizers having low molecular weight will encompass molecular weights less than about 30,000.

The thickness of the photopolymerizable composition layer can vary over a wide range depending upon the type of printing form desired. In one embodiment, the photosensitive layer can have a thickness from about 0.015 inch to about 0.250 inch or greater (about 0.038 to about 0.64 cm or greater). In another embodiment, the photosensitive layer can have a thickness from about 0.107 inch to about 0.300 inch (about 0.27 to about 0.76 cm). In some embodiments, the photosensitive layer can have a thickness from about 0.020 to 0.067 inch (0.5 mm to 1.7 mm). In yet other embodiments, the photosensitive layer can have a thickness from about 0.002 inch to 0.025 inch (0.051 to 0.64 mm). In some embodiments, the thickness of the photosensitive layer provided is greater than the thickness of the continuous photosensitive layer on the sleeve support.

The photosensitive element may optionally include a support adjacent the layer of the photosensitive composition. The support can be composed of any material or combination of materials that is conventionally used with photosensitive elements used to prepare printing forms. In some embodiments, the support is transparent to actinic radiation to accommodate "backflash" exposure through the support. Examples of suitable support materials include polymeric films such those formed by addition polymers and linear condensation polymers, transparent foams and fabrics, such as fiberglass. Under certain end-use conditions, metals such as aluminum, steel, and nickel, may also be used as a support, even though a metal support is not transparent to radiation. In some embodiments, the support is a polyester film. In one embodiment, the support is polyethylene terephthalate film. The support may be in sheet form or in cylindrical form, such as a sleeve. The sleeve can be formed of any material or combination of materials conventionally used in forming sleeves for printing. The sleeve can have a single layer, multi-layer, composite, or unitary structure. Sleeves can be made of polymeric films that are typically transparent to actinic radiation and thereby accommodate backflash exposure for building a floor in the cylindrical printing element. Multiple layered sleeves may include an adhesive layer or tape between the layers of flexible material, such as disclosed in U.S. Patent 5,301,610. The sleeve may also be made of non-transparent, actinic radiation blocking materials, such as nickel or glass epoxy. The sleeve may be composed of one or more layers of a resin composition, which can be the same or different, and have fillers and/or fibers incorporated therein. Materials suitable as the resin composition are not limited, examples of which include, epoxy resins; polystyrene and polyvinyl resins, such as polyvinyl chloride and polyvinyl acetate; phenolic resins; and aromatic amine-cured epoxy resins. The fibers used in the resin composition are not limited and can include, for example, glass fibers, aramid fibers, carbon fibers, metal fibers, and ceramic fibers. Fibers incorporated with the sleeve can include continuous, woven, and/or wound materials. The support formed of a resin composition reinforced with fiber is an example of a composite sleeve. In some embodiments, the support has a thickness from 0.002 to 0.050 inch (0.0051 to 0.127 cm). The sleeve can have a wall thickness from about 0.01 and about 6.35 mm or more. In some embodiments, the sleeve has a wall thickness between about 0.25 and 3 mm. In some embodiments, the sleeve has a wall thickness between about 10 to 80 mils (0.25 to 2.0 mm), and in other embodiments 10 to 40 mils (0.25 to 1.0 mm).

Optionally, the element includes an adhesive layer between the support and the photopolymerizable composition layer, or a surface of the support that is adjacent the photopolymerizable composition layer has an adhesion promoting surface to give strong adherence between the support and the photopolymerizable composition layer.

The photopolymerizable composition layer itself can be prepared in many ways by admixing the binder, monomer, initiator, and other ingredients. It is preferred that the photopolymerizable mixture be formed into a hot melt and then calendered to the desired thickness. An extruder can be used to perform the functions of melting, mixing, deaerating and filtering the composition. To achieve uniform thickness, the extrusion step can be advantageously coupled with a calendering step in which the hot mixture is calendered between two sheets, such as the support and a temporary coversheet, or between one flat sheet and a release roll. Alternately, the material can be extruded/calendered onto a temporary support and later laminated to the desired final support. The element can also be prepared by compounding the components in a suitable mixing device and then pressing the material into the desired shape in a suitable mold. The material is generally pressed between the support and the coversheet. The molding step can involve pressure and/or heat. The coversheet may include one or more of the additional layers which transfer to the photopolymerizable composition layer when the photosensitive element is formed. Cylindrically shaped photopolymerizable elements may be prepared by any suitable method. In one embodiment, the cylindrically shaped elements can be formed from a photopolymerizable printing plate that is wrapped on a carrier or cylindrical support, i.e., sleeve, and the ends of the plate mated to form the cylinder shape. The cylindrically shaped photopolymerizable element can also be prepared according to the method and apparatus disclosed by Cushner et al. in U.S. Patent 5,798,019.

The photosensitive element includes at least one photopolymerizable composition layer, and thus can be a bi- or multi- layer construction. The photosensitive element may include one or more additional layers on or adjacent the photosensitive layer. In most embodiments the one or more additional layers are on a side of the photosensitive layer opposite the support. Examples of additional layers include, but are not limited to, a protective layer, a capping layer, an elastomeric layer, a barrier layer, and combinations thereof. The one or more additional layers can be removable, in whole or in part, during treatment. One or more of the additional layers may cover or only partially cover the photopolymerizable composition layer.

The protective layer protects the surface of the photopolymerizable composition layer and can enable the easy removal of a mask material used for the imagewise exposure of the photosensitive element. The photosensitive element may include an elastomeric capping layer on the at least one photopolymerizable composition layer. The elastomeric capping layer is typically part of a multilayer cover element that becomes part of the photosensitive printing element during calendering of the photopolymerizable composition layer. Multilayer cover elements and compositions suitable as the elastomeric capping layer are disclosed in Gruetzmacher et al., U.S. 4,427,759 and U.S. 4,460,675. In some embodiments, the composition of the elastomeric capping layer includes an elastomeric binder, and optionally a monomer and photoinitiator and other additives, all of which can be the same or different than those used in the bulk photopolymerizable composition layer. Although the elastomeric capping layer may not necessarily contain photoreactive components, the layer ultimately becomes photosensitive when in contact with the underlying bulk photopolymerizable composition layer. As such, upon imagewise exposure to actinic radiation, the elastomeric capping layer has cured portions in which polymerization or crosslinking have occurred and uncured or unirradiated portions which remain unpolymerized, i.e., uncrosslinked. Treating causes the unpolymerized portions of the elastomeric capping layer to be removed along with the photopolymerizable composition layer in order to form the relief surface. The elastomeric capping layer that has been exposed to actinic radiation remains on the surface of the polymerized areas of the photopolymerizable composition layer and becomes the actual printing surface of the printing plate.

The actinic radiation opaque layer is employed in digital direct-to-plate image technology in which laser radiation, typically infrared laser radiation, is used to form a mask of the image for the photosensitive element (instead of the conventional image transparency or phototool). The actinic radiation opaque layer is substantially opaque to actinic radiation that corresponds with the sensitivity of the photopolymerizable material. Digital methods create a mask image *in situ* on or disposed above the photopolymerizable composition layer with laser radiation. Digital methods of creating the mask image require one or more steps to prepare the photosensitive element prior to imagewise exposure. Generally, digital methods of in-situ mask formation either selectively remove or transfer the radiation opaque layer, from or to a surface of the photosensitive element opposite the support. The actinic radiation opaque layer is also sensitive to laser radiation that can selectively remove or transfer the opaque layer. In one embodiment, the actinic radiation opaque layer is sensitive to infrared laser radiation. The method by which the mask is formed with the radiation opaque layer on the photosensitive element is not limited.

In one embodiment, the photosensitive element may include the actinic radiation opaque layer disposed above and covers or substantially covers the entire surface of the photopolymerizable composition layer opposite the support. In this embodiment the infrared laser radiation imagewise removes, i.e., ablates or vaporizes, the radiation opaque layer and forms an in-situ mask as disclosed by Fan in U.S. Patent 5,262,275; Fan in U.S. Patent 5,719,009; Fan in U.S. Patent 6,558,876; Fan in EP 0 741 330 A1; and Van Zoeren in U.S. Patents 5,506,086 and 5,705,310. A material capture sheet adjacent the radiation opaque layer may be present during laser exposure to capture the material as it is removed from the photosensitive element as disclosed by Van Zoeren in U.S. Patent 5,705,310. Only the portions of the radiation opaque layer that were not removed from the photosensitive element will remain on the element forming the in-situ mask.

In some embodiments, the actinic radiation opaque layer comprises a radiation-opaque material, an infrared-absorbing material, and an optional binder. Dark inorganic pigments, such as carbon black and graphite, mixtures of pigments, metals, and metal alloys generally function as both infrared-sensitive material and radiation-opaque material. The optional binder is a polymeric material which includes, but is not limited to, self-oxidizing polymers; non-self-oxidizing polymers; thermochemically decomposable polymers; polymers and copolymers of butadiene and isoprene with styrene and/or olefins; pyrolyzable polymers; amphoteric interpolymers; polyethylene wax, materials conventionally used as a release layer, such as polyamides, polyvinyl alcohol, hydroxyalkyl cellulose, and copolymers of ethylene and vinyl acetate; and combinations thereof. The thickness of the actinic radiation opaque layer should be in a range to optimize both sensitivity and opacity, which is generally from about 20 Angstroms to about 50 micrometers. The actinic radiation opaque layer should have a transmission optical density of greater than 2.0 in order to effectively block actinic radiation and the polymerization of the underlying photopolymerizable composition layer.

In one embodiment, wherein the photosensitive element is cylindrically-shaped, the element further includes an infrared (IR)-sensitive layer on top of the photosensitive layer (or other layers if present). The IR-sensitive layer can form an integrated masking layer for the photosensitive element. The preferred IR-sensitive layer is opaque to actinic radiation that is, has an optical density of at least 1.5; can be imaged, preferably by ablating, with an infrared laser; and removable during treating, i.e., soluble or dispersible in a developer solution or during thermal development. The IR sensitive layer contains material having high absorption in the wavelength (infrared range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or mentals, such as aluminium, copper, etc. The quantity of infrared absorbing material is usually 0.1-40 % by weight, relative to the total weight of the layer. To achieve the desired optical density to block actinic radiation, the infrared-sensitive layer contains a material that prevents the transmission of actinic radiation. In some embodiments, the optical density can be between 2.0 and 3.0. In some embodiments, the optical density can be between 2.6 and 3.4. This actinic radiation blocking material can be the same or different than the infrared absorbing material, and can be, for example, dyes or pigments, and in particular the aforesaid inorganic pigments. The quantity of this material is usually 1-70 % by weight relative to the total weight of the layer. The infrared-sensitive layer optionally includes a polymeric binder, such as, for example, nitrocellulose, homopolymers or copolymers of acrylates, methacrylates and styrenes, polyamides, polyvinyl alcohols, etc. Other auxiliary agents, such as plasticizers, coating aids, etc. are possible. The infrared-sensitive layer is usually prepared by coating a solution or dispersion of the aforesaid components as a layer on the photosensitive layer, and subsequently drying it. The thickness of the infrared-sensitive layer is usually 2 nm to 50 µm, preferably 4 nm to 40 µm. These infrared-sensitive layers and their preparation are described in detail, for example in WO 94/03838 and WO 94/3839.

In the embodiments comprising the cylindrically-shaped elements, the cylindrically-shaped photosensitive element is converted to the cylindrically-shaped printing form by undergoing conventional steps of exposing (including imagewise exposure and optionally backflash exposure) and treating to form a relief surface on the printing form suitable for flexographic printing.

The process includes the step of providing a layer of a photosensitive composition and attaching the layer of photosensitive composition to the cylindrically-shaped support. In some embodiments, attachment or bonding or joining ("attachment") of the cylindrically-shaped support to the photosensitive layer includes preheating the cylindrically-shaped support and/or the photosensitive layer prior to their contacting of each other for adhesion purposes (the "preheating step"). In other embodiments, attachment of the cylindrically-shaped support to the photosensitive layer is accomplished by introducing an adhesive layer in between the cylindrically-shaped support and the photosensitive layer (the "adhesive step"). In some embodiments, the adhesive step in combination with the preheating step is used for attachment purposes. Filed application IM1352 describes in detail the preheating step of attaching the photosensitive layer to the cylindrically-shaped support. The method by which the photosensitive layer is applied to the cylindrically-shaped support is not limited. The present invention pertains to providing a seamless and smooth surface of the photosensitive element by exposure to finishing medium after the photosensitive element has been attached to the cylindrically-shaped support.

Any thermoplastically processable solid photosensitive layer that can be joined to itself under the influence of heat and pressure without its photosensitive properties being adversely affected are suitable for use. Also included are those photosensitive layers, not necessarily thermoplastic, but can be thermoplastic, which adhere to the cylindrically-shaped support by adhesion means such as an adhesion promoting agent between the photosensitive layer and the outer surface of the cylindrically-shaped support.

Thermoplastically processable solid photosensitive layers include, in particular, the solid, polymeric, photosensitive layers which soften on heating or exhibit adhesive bonding under pressure as known per se for the production of printing relief plates. The solid photosensitive layer includes at least a thermoplastic binder, monomer, and photoinitiator. As used herein, the term "solid" refers to the physical state of the layer that has a definite volume and shape and resists forces that tend to alter its volume or shape. The photosensitive layer is generally considered a solid at room temperature.

The exposure process usually comprises a back exposure and a front image-wise exposure, although the former is not strictly necessary. The back exposure or "backflash" can take place before, after or during image-wise exposure. Backflash prior to image-wise exposure is generally preferred.

Optionally, the photosensitive layer may be overall exposed to actinic radiation to form a floor of a shallow layer of polymerized material in the layer, after preheating or exposure to finishing medium. Overall exposure to form a floor is often referred to as a backflash exposure. In an embodiment where the photosensitive layer is backflash exposed prior to contacting the layer to the support, the backflash exposure is given to the contact surface of the photosensitive layer since the floor that is formed will be adjacent to the support. In some embodiments, the backflash exposure occurs after the sheet support (if present) is removed from the contact surface of the photosensitive layer. In other embodiments, the backflash exposure occurs before the sheet support (if present) is removed from the contact surface of the photosensitive layer. Back flash time can range from a few seconds to about 10 minutes. The backflash exposure can sensitize the photosensitive layer, help highlight dot resolution and also establish the depth of relief for the printing form. The floor provides better mechanical integrity to the photosensitive element. In some embodiments, the backflash exposure can occur after the cylindrically-shaped photosensitive element is formed provided that the cylindrical support is transparent to the actinic radiation. In this instance the exposure to form the floor may also improve adhesion of the photosensitive layer to the support. In some embodiments, the backflash exposure can occur after cylindrically-shaped photosensitive element is formed but prior to exposure to finishing medium for removal of portion of photopolymerizable layer for preparing a seamless and smooth surface of the cylindrically-shaped photosensitive element. In some embodiments, the backflash exposure can occur after cylindrically-shaped photosensitive element is formed and after the step of exposure of the cylindrically-shaped photosensitive element to finishing medium for removal of portion of photopolymerizable layer from the photosensitive element for preparing a seamless and smooth surface of the cylindrically-shaped photosensitive element. It should be noted that the backflash exposure generally occurs prior to the exposure of the photosensitive element to the actinic radiation for preparing the relief form. Similarly, it should also be noted that in one embodiment, the step of exposure to finishing medium for removal of a portion of the photopolymerizable layer from the photosensitive element generally occurs prior to the exposure of the photosensitive element to the actinic radiation for preparing the relief form. However, in another embodiment, the step of exposure to finishing medium for removal of a portion of the photopolymerizable layer from the photosensitive element can occur after the exposure of the photosensitive element to the actinic radiation for preparing the relief form.

Upon imagewise exposure, the radiation-exposed areas of the photosensitive layer are converted to the insoluble state with no significant polymerization or crosslinking taking place in the unexposed areas of the layer. Any conventional source of actinic radiation can be used for this exposure. Examples of suitable radiation sources include xenon lamps, mercury vapor lamps, carbon arcs, argon glow lamps, fluorescent lamps with fluorescent materials emitting UV radiation and electron flash units, and photographic flood lamps. Typically, a mercury vapor arc or a sunlamp can be used at a distance of about 1.5 to about 60 inches (about 3.8 to about 153 cm) from the photosensitive element. These radiation sources generally emit long-wave UV radiation between 310-400 nm. The exposure time may vary from a few seconds to minutes, depending upon the intensity and spectral energy distribution of the radiation, its distance from the photosensitive element, and the nature and amount of the photopolymerizable material.

Imagewise exposure can be carried out by exposing the photosensitive element through an image-bearing photomask. The photomask can be a separate film, i.e., an image-bearing transparency or phototool, such as a silver halide film; or the photomask can be integrated with the photosensitive element as described above. In the case in which the photomask is a separate film, the optional cover sheet is usually stripped before imagewise exposure leaving the release layer on the photosensitive element. The photomask is brought into close contact with the release layer of the photosensitive element by the usual vacuum processes, e.g., by use of a common vacuum frame. Thus a substantially uniform and complete contact between the photosensitive element and the photomask can be achieved in acceptable time.

It is preferred to form the integrated photomask on the cylindrical photosensitive element. In a particularly preferred embodiment, the photosensitive element includes the IR-sensitive layer which becomes the integrated photomask. The IR-sensitive layer is imagewise exposed to IR laser radiation to form the photomask on the photosensitive element. The infrared laser exposure can be carried out using various types of infrared lasers, which emit in the range 750 to 20,000 nm. Infrared lasers including, diode lasers emitting in the range 780 to 2,000 nm and Nd:YAG lasers emitting at 1064 nm are preferred. In so-called digital imaging, the radiation opaque layer is exposed imagewise to infrared laser radiation to form the image on or disposed above the photopolymerizable composition layer, i.e., the in-situ mask. The infrared laser radiation can selectively remove, e.g., ablate or vaporize, the infrared sensitive layer (i.e., radiation opaque layer) from the photopolymerizable composition layer, as disclosed by Fan in U.S. Patents 5,262,275 and 5,719,009; and Fan in EP 0 741 330 B1. The integrated photomask remains on the photosensitive element for subsequent steps of UV pre-exposure, imagewise main exposure to actinic radiation and development.

In another embodiment, the mask can be formed digitally. For digitally forming the in-situ mask, the photosensitive element will not initially include the actinic radiation opaque layer. A separate element bearing the radiation opaque layer will form an assemblage with the photosensitive element such that the radiation opaque layer is adjacent the surface of the photosensitive element opposite the support, which is typically is the photopolymerizable composition layer. (If present, a coversheet associated with the photosensitive element typically is removed prior to forming the assemblage.) The separate element may include one or more other layers, such as ejection layers or heating layers, to aid in the digital exposure process. Hereto, the radiation opaque layer is also sensitive to infrared radiation. The assemblage is exposed imagewise with infrared laser radiation to selectively transfer or selectively alter the adhesion balance of the radiation opaque layer and form the image on or disposed above the photopolymerizable composition layer as disclosed by Fan et al. in U.S. Patent 5,607,814; and Blanchett in U.S. Patents 5,766,819; 5,840,463; and EP 0 891 877 A. As a result of the imagewise transfer process, only the transferred portions of the radiation opaque layer will reside on the photosensitive element forming the in-situ mask.

In another embodiment, digital mask formation can be accomplished by imagewise application of the radiation opaque material in the form of inkjet inks on the photosensitive element. Imagewise application of an ink-jet ink can be directly on the photopolymerizable composition layer or disposed above the photopolymerizable composition layer on another layer of the photosensitive element. Another contemplated method that digital mask formation can be accomplished is by creating the mask image of the radiation opaque layer on a separate carrier. In some embodiments, the separate carrier includes a radiation opaque layer that is imagewise exposed to laser radiation to selectively remove the radiation opaque material and form the image. The mask image on the carrier is then transferred with application of heat and/or pressure to the surface of the photopolymerizable composition layer opposite the support. The photopolymerizable composition layer is typically tacky and will retain the transferred image. The separate carrier can then be removed from the element prior to the pre-exposure and/or the imagewise exposure. The separate carrier may have an infrared sensitive layer that is imagewise exposed to laser radiation to selectively remove the material and form the image. An example of this type of carrier is LaserMask^{®} imaging film by Rexam, Inc.

The photosensitive printing element may also include a temporary coversheet on top of the uppermost layer of the element, which is removed prior to preparation of the printing form. One purpose of the coversheet is to protect the uppermost layer of the photosensitive printing element during storage and handling. Examples of suitable materials for the coversheet include thin films of polystyrene, polyethylene, polypropylene, polycarbonate, fluoropolymers, polyamide or polyesters, which can be subbed with release layers. The coversheet is preferably prepared from polyester, such as Mylar^{®} polyethylene terephthalate film.

Following overall exposure to UV radiation through the image-bearing mask, the photosensitive element is treated to remove unpolymerized areas in the photopolymerizable composition layer and thereby form a relief image. For the present invention, treatment of the photosensitive printing element includes one or more of the thermal processes and/or one or more of the solvent-based processes (wet processes). For example, in a thermal photopolymerizable composition layer development, the photopolymerizable composition layer is heated to a development temperature which causes the unpolymerized areas to melt or soften and is contacted with an absorbent material of the development medium to wick away the unpolymerized material.

The printing form, after exposure (and treating) of the photosensitive element, has a durometer of about 20 to about 85 Shore A. The Shore durometer is a measure of the resistance of a material toward indentation. Durometer of Shore A is the scale typically used for soft rubbers or elastomeric materials, where the higher the value the greater the resistance toward penetration. In one embodiment, the printing form has a Shore A durometer less than about 50 to about 20. In another embodiment, the printing form has a Shore A durometer less than about 40 to about 25. In another embodiment, the printing form has a Shore A durometer less than about 35 to about 30. Printing forms having a Shore A durometer less than about 40 are particularly suited for printing on corrugated paperboard. The durometer of the printing form can be measured according to standardized procedures described in DIN 53,505 or ASTM D2240-00. In some embodiments, the printing form can be mounted onto a carrier having the same or different resilience than that of the printing form. The resilience of the carrier can influence the overall resilience of the overall print form package (that is, carrier and printing form) resulting in a durometer of the package different from that of the printing form.

### EXPERIMENTAL

### Example 1

Two Cyrel(R) photosensitive plates (from E. I. du Pont de Nemours & Co. Wilmington, Del.) were placed side-by-side with the edges to be welded placed in close proximity. A moderate horizontal force was applied on the two plates holding the plates in place. The plates were mounted on a Teflon(R) backing or support.

The microwave-radiation apparatus comprising the aluminum focused waveguide applicator was positioned over the Cyrel (R) plates, such that the desired weld-line was at the focal point of the impending microwave-radiation. The applicator had an aperture of 86 mm X 6 mm. The length of the focusing portion, from the waveguide junction to the aperture was 90 mm. The applicator was attached to a standard WR-340 waveguide with the cross sectional dimensions of 86 mm X 430 mm. The microwave power source was manufactured by Astex, Inc., Model No. AX2115, with a maximum power output of 1500W, a frequency of 2.450 GHz; and was connected to a magnetron source made by Astex model no. SXRHA. The microwave waveguide was operated in the TE₁₀ mode. The microwave power was tuned to 500W. The impingement of microwave-radiation was for 4 seconds.

Table 1 shows the result of the above experiment. The two plates were successfully welded. The weld-line between the two Cyrel(R) plates was visible. However, there were no indentations from the welding process.

### Example 2

Two Cyrel(R) photosensitive plates (from E. I. du Pont de Nemours & Co. Wilmington, Del.) were placed side-by-side with the edges to be welded placed in close proximity. A moderate horizontal force was applied on the two plates holding the plates in place. The plates were mounted on a Teflon(R) backing or support.

The microwave-radiation apparatus comprising the aluminum focused waveguide applicator was positioned over the Cyrel (R) plates, such that the desired weld-line was at the focal point of the impending microwave-radiation. The applicator had an aperture of 86 mm X 6 mm. The length of the focusing portion, from the waveguide junction to the aperture was 90 mm. The applicator was attached to a standard WR-340 waveguide with the cross sectional dimensions of 86 mm X 430 mm. The microwave power source was manufactured by Astex, Inc., Model No. AX2115, with a maximum power output of 1500W, a frequency of 2.450 GHz; and was connected to a magnetron source made by Astex model no. SXRHA. The microwave waveguide was operated in the TE₁₀ mode. The microwave power was tuned to 500W. The impingement of microwave-radiation was for 6 seconds.

Table 1 shows the result of the above experiment, the two plates were successfully welded. The weld-line between the two Cyrel(R) plates although visible, was much less prominent compared to the weld-line in Example 1. Also, there were no indentations from the welding process. A slight discoloration on the Cyrel(R) plates was observed from the plates sticking to the Teflon(R) backing.

### Example 3

Two Cyrel(R) photosensitive plates (from E. I. du Pont de Nemours & Co. Wilmington, Del.) were placed side-by-side with the edges to be welded placed in close proximity. A moderate horizontal force was applied on the two plates holding the plates in place. The plates were mounted on a Teflon(R) backing or support.

The microwave-radiation apparatus comprising the aluminum focused waveguide applicator was positioned over the Cyrel (R) plates, such that the desired weld-line was at the focal point of the impending microwave-radiation. The applicator had an aperture of 86 mm X 6 mm. The length of the focusing portion, from the waveguide junction to the aperture was 90 mm. The applicator was attached to a standard WR-340 waveguide with the cross sectional dimensions of 86 mm X 430 mm. The microwave power source was manufactured by Astex, Inc., Model No. AX2115, with a maximum power output of 1500W, a frequency of 2.450 GHz; and was connected to a magnetron source made by Astex model no. SXRHA. The microwave waveguide was operated in the TE₁₀ mode. The microwave power was tuned to 750W. The impingement of microwave-radiation was for 8 seconds.

Table 1 shows the result of the above experiment. The two plates were successfully welded. The weld-line between the two Cyrel(R) plates was not visible at all. Also, there were no indentations from the welding process. Even the weld-line discoloration issue, seen in Example 2, was resolved. No discoloration was seen in the welded samples.

**Table 1**

| **Ex. No.** | **Microwave Frequency (GHz)** | **Micro-wave Power (W)** | **Expo-sure (s)** | **Weld-Line** | **Discoloration** |
|---|---|---|---|---|---|
| **1.** | 2.450 | 500 | 4 | Prominently visible; no indentations | No discoloration |
| **2.** | 2.450 | 500 | 6 | Faintly visible | Slight discoloration |
| **3.** | 2.450 | 750 | 8 | Not visible | No discoloration |

## Claims

1. A process for welding at least two photosensitive elements to each other, for use as a printing form, comprising:
(a) providing said at least two photosensitive elements, each comprising a photosensitive layer comprising a thermoplastic binder, a monomer and a photoinitiator;
(b) placing said at least two photosensitive elements side-by-side such that an edge of the first photosensitive element to be welded with an edge of the second photosensitive element are in intimate contact with one another and form a weld-line; and
(c) applying microwave-radiation from a microwave-radiation means, wherein said microwave-radiation impinges on an area substantially proximate to said edges.

2. The process as recited in claim 1, wherein said at least two photosensitive elements are planar-shaped.

3. The process as recited in claim 1, wherein said at least two photosensitive elements are cylindrically-shaped elements and said edge of said first photosensitive element and said edge of said second photosensitive element relate to one of the two circular edges of each of said at least two photosensitive elements.

4. The process of claim 1 wherein said edge of said first photosensitive element overlaps said edge of said second photosensitive element.

5. A process for welding two edges of a cylindrically-shaped photosensitive element to each other, for using said photosensitive element as a printing form, the process comprising:
(a) providing said photosensitive element, comprising a photosensitive layer comprising a thermoplastic binder, a monomer and a photoinitiator;
(b) placing said two edges of the cylindrically-shaped photosensitive element side-by-side such that the two edges to be welded to each other are in intimate contact with one another and form a weld-line; and
(c) applying microwave-radiation from a microwave-radiation means, wherein said microwave-radiation impinges on an area substantially proximate to said edges.

6. The process of claim 5 wherein said two edges of the cylindrically-shaped photosensitive element overlap each other.

7. The process as recited in claim 1 or claim 5, wherein said weld-line is non-uniform.

8. The process as recited in claim 1 or claim 5, wherein said photosensitive element(s) exposed to said microwave-radiation is/are not imagewise exposed to actinic radiation at the time of exposure to microwave-radiation.

9. The process as recited in claim 1 or claim 5, wherein said photosensitive element(s) exposed to said microwave-radiation is/are imagewise exposed to actinic radiation at the time of the exposure to microwave-radiation.

10. The process as recited in claim 8, wherein said photosensitive element(s) is/are further imagewise exposed to actinic radiation.

11. The process as recited in claim 9 or claim 10, wherein said photosensitive elements are developed by thermal development process or solvent development process.

12. The process as recited in claim 1 or claim 5, wherein said microwave-radiation frequency is in the range of from 300 MHz to 30,000 MHz, preferably selected from the group consisting of 433 MHz, 896 MHz, 915 MHz, 2,450 MHz, 5,800 MHz, and 24,000 MHz.

13. The process as recited in claim 1 or claim 5, wherein the microwave-radiation is impinged on said area substantially proximate to said weld-line for a time interval in the range of from 1 s to 120 s, preferably from 1 s to 10 s.

14. The process as recited in claim 1 or claim 5, wherein the microwave power supplied is in the range of from 100 W to 2,000 W, preferably from 450 W to 800 W.

15. A flexographic printing form made according to the process of any one of claims 1 to 14.

## Patentansprüche

1. Verfahren zum Zusammenschweißen zumindest zweier lichtempfindlicher Elemente, die als Druckform verwendet werden, umfassend:
(a) Bereitstellen der zumindest zwei lichtempfindlichen Elemente, wobei jedes Element eine einen thermoplastischen Binder, ein Monomer und einen Photoinitiator enthaltende Schicht umfasst;
(b) Nebeneinanderstellen der zumindest zwei lichtempfindlichen Elemente sodass eine mit einer Kante des zweiten lichtempfindlichen Elements zu schweißende Kante des ersten lichtempfindlichen Elements mit dieser in innigen Kontakt steht, und beide eine Schweiß linie bilden; und
(c) Beaufschlagen mit Mikrowellenstrahlung aus einem Mikrowellen strahlenden Mittel, wobei die Mikrowellenstrahlung einen den Kanten im Wesentlichen nahen Bereich beaufschlagt.

2. Verfahren nach Anspruch 1, wobei die zumindest zwei lichtempfindlichen Elemente eine plane Form aufweisen.

3. Verfahren nach Anspruch 1, wobei die zumindest zwei lichtempfindlichen Elemente zylinderförmige Elemente sind und die Kante des ersten lichtempfindlichen Elements und die Kante des zweiten lichtempfindlichen Elements einer der zwei kreisförmigen Kanten jedes der zumindest zwei lichtempfindlichen Elemente zugeordnet sind.

4. Verfahren nach Anspruch 1, wobei sich die Kante des ersten lichtempfindlichen Elements mit der Kante des zweiten lichtempfindlichen Elements überlappt.

5. Verfahren zum Zusammenschweißen zweier Kanten eines zylinderförmigen lichtempfindlichen Elements zur Verwendung des lichtempfindlichen Elements als Druckform, wobei das Verfahren Folgendes umfasst:
(a) Bereitstellen des lichtempfindlichen Elements, das eine einen thermoplastischen Binder, ein Monomer und einen Photoinitiator enthaltende lichtempfindliche Schicht umfasst;
(b) Nebeneinanderstellen der zwei Kanten des zylinderförmigen lichtempfindlichen Elements so dass die zwei zusammenzuschweißenden Kanten in innigem Kontakt zueinander stehen und eine Schweißlinie bilden; und
(c) Beaufschlagen mit Mikrowellenstrahlung aus einem Mikrowellen strahlenden Mittel, wobei die Mikrowellenstrahlung einen den Kanten im Wesentlichen nahen Bereich beaufschlagt.

6. Verfahren nach Anspruch 5, wobei die zwei Kanten des zylinderförmigen lichtempfindlichen Elements sich überlappen.

7. Verfahren nach Anspruch 1 oder Anspruch 5, wobei die Schweißlinie ungleichförmig ist.

8. Verfahren nach Anspruch 1 oder Anspruch 5, wobei das lichtempfindliche Element oder die lichtempfindlichen Elemente, das oder die von der Mikrowellenstrahlung beaufschlagt ist/sind, zur Zeit der Bestrahlung mit Mikrowellen bildmäßig nicht aktinischer Strahlung ausgesetzt ist/sind.

9. Verfahren nach Anspruch 1 oder Anspruch 5, wobei das lichtempfindliche Element oder die lichtempfindlichen Elemente, das oder die von der Mikrowellenstrahlung beaufschlagt ist/sind, zur Zeit der Bestrahlung mit Mikrowellen bildmäßig aktinischer Strahlung ausgesetzt ist/sind.

10. Verfahren nach Anspruch 8, wobei das lichtempfindliche Element oder die lichtempfindlichen Elemente ferner bildmäßig aktinischer Strahlung ausgesetzt ist/sind.

11. Verfahren nach Anspruch 9 oder Anspruch 10, wobei die lichtempfindlichen Elemente mittels eines thermischen Entwicklungsverfahrens oder eines lösungsmittelbasierten Entwicklungsverfahrens entwickelt werden.

12. Verfahren nach Anspruch 1 oder Anspruch 5, wobei die Frequenz der Mikrowellenstrahlung sich im Bereich zwischen 300 MHz und 30.000 MHz befindet, und bevorzugt aus der Gruppe umfassend 433 MHz, 896 MHz, 915 MHz, 2.450 MHz, 5.800 MHz und 24.000 MHz ausgewählt wird.

13. Verfahren nach Anspruch 1 oder Anspruch 5, wobei die Mikrowellenstrahlung den im Wesentlichen der Schweiß linie benachbarten Bereich während einer Zeit im Bereich von 1 s bis 120 s, bevorzugt von 1 s bis 10 s beaufschlagt.

14. Verfahren nach Anspruch 1 oder Anspruch 5, wobei die gelieferte Mikrowellenleistung im Bereich von 100 W bis 2.000 W, bevorzugt von 450 W bis 800 W liegt.

15. Flexodruckform, die gemäß dem Verfahren nach einem der Ansprüche 1 bis 14 hergestellt worden ist.

## Revendications

1. Procédé de soudage d'au moins deux éléments photosensibles l'un à l'autre, pour une utilisation en tant que forme d'impression, comprenant les étapes consistant à :
(a) fournir lesdits au moins deux éléments photosensibles, chaque élément comprenant une couche photosensible comprenant un liant thermoplastique, un monomère et un photo-initiateur ;
(b) placer lesdits au moins deux éléments photosensibles côte à côte de telle manière qu'un bord du premier élément photosensible à souder à un bord du second élément photosensible et ledit bord sont en contact intime l'un avec l'autre et forment une ligne de soudure ; et
(c) appliquer un rayonnement micro-ondes en provenance d'un moyen de rayonnement micro-ondes, dans lequel ledit rayonnement micro-ondes est incident sur une zone substantiellement proche desdits bords.

2. Procédé selon la revendication 1, dans lequel lesdits au moins deux éléments photosensibles sont de forme plane.

3. Procédé selon la revendication 1, dans lequel lesdits au moins deux éléments photosensibles sont des éléments de forme cylindrique et ledit bord dudit premier élément photosensible et ledit bord dudit second élément photosensible désignent un des deux bords circulaires de chacun desdits au moins deux éléments photosensibles.

4. Procédé selon la revendication 1, dans lequel ledit bord dudit premier élément photosensible chevauche ledit bord du second élément photosensible.

5. Procédé de soudage de deux bords d'un élément photosensible de forme cylindrique l'un à l'autre, pour utiliser ledit élément photosensible en tant que forme d'impression, le procédé comprenant les étapes consistant à :
(a) fournir ledit élément photosensible, comprenant une couche photosensible comprenant un liant thermoplastique, un monomère et un photo-initiateur ;
(b) placer lesdits deux bords de l'élément photosensible de forme cylindrique côte à côte de telle manière que les deux bords à souder l'un à l'autre sont en contact intime l'un avec l'autre et forment une ligne de soudure ; et
(c) appliquer un rayonnement micro-ondes en provenance d'un moyen de rayonnement micro-ondes, dans lequel ledit rayonnement micro-ondes est incident sur une zone substantiellement proche desdits bords.

6. Procédé selon la revendication 5, dans lequel lesdits deux bords de l'élément photosensible de forme cylindrique se chevauchent l'un l'autre.

7. Procédé selon la revendication 1 ou 5 dans lequel ladite ligne de soudure n'est pas uniforme.

8. Procédé selon la revendication 1 ou 5, dans lequel le(s)dit(s) élément(s) photosensible(s) exposé(s) audit rayonnement micro-ondes n'est/ne sont pas exposé(s) en mode image à un rayonnement actinique au moment de l'exposition au rayonnement micro-ondes.

9. Procédé selon la revendication 1 ou 5, dans lequel le(s)dit(s) élément(s) photosensible(s) exposé(s) audit rayonnement micro-ondes est/sont exposé(s) en mode image à un rayonnement actinique au moment de l'exposition au rayonnement micro-ondes.

10. Procédé selon la revendication 8, dans lequel le(s)dit(s) élément(s) photosensible(s) est/sont en outre exposé(s) en mode image au rayonnement actinique.

11. Procédé selon la revendication 9 ou 10, dans lequel lesdits éléments photosensibles sont développés grâce à un procédé de développement thermique ou un procédé de développement faisant intervenir des solvants.

12. Procédé selon la revendication 1 ou 5, dans lequel la fréquence dudit rayonnement micro-ondes est comprise dans la plage de 300 MHz à 30 000 MHz, de manière préférée sélectionnée parmi le groupe constitué de 433 MHz, 896 MHz, 915 MHz, 2 450 MHz, 5 800 MHz et 24 000 MHz.

13. Procédé selon la revendication 1 ou 5, dans lequel le rayonnement micro-ondes est incident sur ladite zone substantiellement proche de ladite ligne de soudure pendant un intervalle de temps compris dans la plage de 1 s à 120 s, de manière préférée de 1 s à 10 s.

14. Procédé selon la revendication 1 ou 5, dans lequel la puissance de micro-ondes fournie est comprise dans la plage de 100 W à 2 000 W, de manière préférée de 450 W à 800 W.

15. Forme d'impression flexographique réalisée conformément au procédé selon l'une quelconque des revendications 1 à 14.
